# EUROPÄISCHE PATENTSCHRIFT

(11) **EP 0 420 345 B1**
(45) Veröffentlichungstag und Bekanntmachung des Hinweises auf die Patenterteilung: **03.08.1994**
(21) Anmeldenummer: 90202533.7
(22) Anmeldetag: 25.09.1990
(51) Int. Cl.: G01R 29/24

(54) **Influenzsonde**
Influence probe
Sonde à influence

(30) Priorität: 28.09.1989 DE 3932335
(43) Veröffentlichungstag der Anmeldung: 03.04.1991
(73) Patentinhaber: Philips Patentverwaltung GmbH, 22335 Hamburg (DE); Philips Electronics N.V., 5621 BA Eindhoven (NL)
(72) Erfinder: Maack, Hanns-Ingo, D-2000 Norderstedt (DE); Hillen, Walter, Dr., D-5100 Aachen (DE); Schiebel, Ulrich, Dr., D-5100 Aachen (DE)
(74) Vertreter: von Laue, Hanns-Ulrich, Dipl.-Ing.

(56) Entgegenhaltungen:
- EP-A- 0 030 056
- DE-A- 2 951 814
- US-A- 4 622 574
- NTIS TECH NOTES. September 1988, SPRINGFIELD, VA US Seiten 764 - 1-2; P.A.Robinson Jr.: "MOSFET electric-charge sensor"

## Beschreibung

Die Erfindung betrifft eine Influenzsonde gemäß dem Oberbegriff des Anspruchs 1. Eine derartige Influenzsonde ist aus der DE-OS 29 48 660 bekannt.

In der Elektrofotografie bzw. in der Elektroradiografie entstehen zunächst elektrostatische (latente) Ladungsbilder. Es ist möglich, derartige Ladungsbilder mit Hilfe von Influenzsonden elektronisch auszulesen und so z.B. der Bildverarbeitung in einem Rechner zugänglich zu machen. In diesem Fall müssen die Bildträger, auf denen sich die Ladungsverteilung befindet (es kann sich z.B. um Selenplatten o.dgl. handeln), mit Influenzsonden abgetastet werden.

Für die möglichst genaue Erfassung der Ladungsverteilung kommt es zum einen darauf an, daß in der Meßsonde möglichst wenig Leckströme auftreten und daß die Öffnung der Deckschicht, die sogenannte Apertur, möglichst klein gehalten werden kann und einen genau definierten Abstand zur Substratoberfläche aufweist.

Die aus der DE-OS 29 48 660 bekannte Influenzsonde ist auf einem Substrat aufgebaut, welches auf der Sondenseite im Bereich der Apertur der Sonde eine erhobene Fläche aufweist, an die sich seitlich abgewinkelte Seitenflächen anschließen. Die Sondenelektrode, die Isolierschicht und die Deckschicht werden jeweils durch Kathodenzerstäubung oder durch Aufdampfen aufgebracht. In einem nächsten Arbeitsgang wird dann die erforderliche Form durch Herausätzen von Teilen der Schicht gebildet, wobei Fotomasken erforderlich sind, die die Neigung der Seitenflächen berücksichtigen. Diese Sonden sind also für eine industrielle Herstellung zu aufwendig.

Aus der DE-OS 29 51 814 ist eine z.B. bei einem elektrostatischen Kopiergerät eingesetzte Elektrometereinrichtung bekannt, bei der auf einem Träger nebeneinander eine Elektrode und ein Abschirmstreifen aufgedruckt sind.

Es ist Aufgabe der Erfindung, eine Influenzsonde der eingangs genannten Art dahingehend weiterzuentwickeln, daß sie trotz präziser einzuhaltender Abmessungen auf einfache Weise großtechnisch herstellbar ist.

Diese Aufgabe wird erfindungsgemäß durch die im kennzeichnenden Teil des Anspruchs 1 angegebenen Maßnahmen gelöst.

Bei diesem Aufbau der Sonde ist zunächst an das Substrat keine erhöhte Anforderung zu stellen; es muß lediglich eine ebene Oberfläche aufweisen. Die Erhöhungen der Influenzsonde im Bereich der Öffnung der Deckelelektrode werden durch die verschiedenen aufgebrachten Schichten gezielt erzeugt. Dies geschieht in der Weise, daß auf die Substratoberfläche zunächst die Sondenelektrode in Dickschicht-Drucktechnik aufgebracht wird. Auf die Sondenelektrode wird dann eine Isolierschicht aufgebracht. Diese Isolierschicht deckt die Sondenelektrode vollständig ab. Auf die Isolierschicht wiederum wird, ebenso in Dickschichttechnik, eine elektrisch leitende Deckschicht aufgebracht, welche wiederum die Isolierschicht vollständig abdeckt. Die Isolierschicht dient vor allem dazu, eine Isolation zwischen der Sondenelektrode und der Deckschicht zu schaffen. Je dicker die Isolierschicht ist, umso besser ist die Isolation zwischen der Sondenelektrode und der Deckschicht und umso geringer ist die Kapazität zwischen diesen beiden.

Da die Sondenelektrode vollständig abgedeckt ist, ist zu ihrer elektrischen Kontaktierung vorgesehen, diese mittels einer in einer Öffnung des Substrats vorgesehenen Durchkontaktierung vorzunehmen.

Bei der Aufbringung der verschiedenen Schichten mittels Dickschicht-Drucktechnik kann deren Dicke recht genau eingestellt werden. Damit ist die Höhe der Deckschicht im Bereich deren Öffnung gegenüber der Substratoberfläche genau einstellbar. Dies gilt auch für mehrere, auf einem Substrat vorgesehene Sonden. Damit wird eine Justage des Abstandes der Sonden relativ zu einem Bildträger, dessen Ladungen mittels der Sonden abgetastet werden soll, vereinfacht.

Die Anwendung der Dickschicht-Technik gestattet es auch, die verschiedenen Schichten in der gewünschten relativen Lage zueinander auf das Substrat aufzubringen. Die Influenzsonde ist also bei genauer Einhaltung von vorgegebenen Soll-Abmessungen in wirtschaftlicher Weise industriell herstellbar. Die Durchkontaktierung mittels Dickschicht-Drucktechnik kann beispielsweise dadurch geschehen, daß die Durchkontaktierung mittels je eines Druckvorgangs von beiden Seiten des Substrats gebildet wird. Die Erstellung der Durchkontaktierung kann damit in dem gleichen Arbeitsverfahren erfolgen wie die Herstellung der Sonde.

Nach einer Ausgestaltung der Erfindung ist vorgesehen, daß die Durchkontaktierung der Sondenelektrode außerhalb desjenigen Bereichs der Elektrode angeordnet ist, auf den Ladung influenziert werden soll. Je nach gewählter Dicke des Substrats kann sich auf der Sondenseite eine leichte Einbeulung dadurch ergeben, daß das Material, das die Durchkontaktierung bildet, im Bereich der Öffnung des Substrats relativ stark in die Öffnung hineinfließt. Eine solche Einbeulung könnte sich eventuell bis zur Deckschicht fortpflanzen, so daß die genauen geometrischen Abmessungen nicht mehr einzuhalten wären. Zur Vermeidung dieses Nachteils ist daher vorgesehen, daß die Durchkontaktierung in Aufsicht auf das Substrat neben demjenigen Bereich der Sondenelektrode, auf den Ladung influenziert werden soll, angeordnet ist.

Eine weitere Ausgestaltung der Erfindung sieht vor, daß die Isolierschicht in mehreren Druckschichten aufgebracht ist. Durch die Wahl der Dicke der Isolierschicht kann die Höhe der Deckschicht gegenüber der Substratoberfläche und damit auch der Abstand zwischen der Deckschicht und der Sondenelektrode eingestellt werden. Sollte z.B. eine Höhe von 100 µm vorgesehen sein, ist es vorteilhaft, die Isolierschicht in mehreren Druckschichten aufzubringen, da sie so eventuelle geringe örtliche Schwankungen der Dicke der einzelnen Isolierschichten im Mittel gegeneinander aufheben. Auch sind Störungen in den Druckschichten besser kontrollierbar, wenn die Druckschichten dünner sind. Für die Erzeugung einer Influenzsonde mit einer Gesamthöhe von 100 µm kann die Isolierschicht beispielsweise in fünf Einzelschichten aufgebracht sein.

Für eine Ausführungsform der Sonde mit mehreren Isolierschichten ist nach einer Ausgestaltung der Erfindung vorgesehen, daß die auf die Sondenelektrode aufgebrachte Teilschicht diese vollständig abdeckt, daß die weiteren Teil-Isolierschichten zur Deckschicht hin eine abnehmende Flächenausdehnung aufweisen und daß die unter der Deckschicht 14 befindliche Teil-Isolierschicht sich wenigstens unterhalb der Öffnung 15 der Deckschicht 14 erstreckt. Die Teil-Isolierschicht, welche direkt auf die Sondenelektrode aufgebracht ist, weist also die größte Flächenausdehnung auf. Jede auf ihr aufgebrachte Teil-Isolierschicht weist jeweils eine etwas kleinere Flächenausdehnung auf als die unter ihr befindliche Teil-Isolierschicht. Auf diese Weise weist die anschließend über die Teil-Isolierschichten aufgrebrachte Deckschicht eine sich zu dem Bereich, in der diese eine Öffnung aufweist, verjüngende Struktur auf. In jedem Falle muß jedoch sichergestellt sein, daß die oberste Teil-Isolierschicht sich wenigstens unterhalb der Öffnung der Deckschicht erstreckt.

Nach einer weiteren Ausgestaltung der Erfindung ist vorgesehen, daß die Sondenelektrode mittels der Durchkontaktierung mit einer auf der Gegenseite des Substrats angeordneten Schaltungsanordnung zur Signalverstärkung verbunden ist. Die Schaltungsanordnung kann also auf dem gleichen Substrat vorgesehen sein wie die Influenzsonde, jedoch nicht auf der Sondenseite, sondern auf der Gegenseite. Über die Durchkontaktierung ist dabei ein äußerst kurzer Signalweg gegeben.

Eine weitere Ausgestaltung der Erfindung sieht vor, daß bei Anordnung mehrerer Sonden nebeneinander auf einem Substrat diese eine gemeinsame Deckschicht aufweisen. In diesem Falle ergibt sich eine weitere Vereinfachung der Fertigung, da die Deckschicht für mehrere Sonden gemeinsam erzeugt werden kann.

Die Erfindung wird nachstehend anhand der Zeichnung näher erläutert. Es zeigen:
Fig. 1 ein Substrat in Seitenansicht mit einer Influenzsonde in Schnittdarstellung und
Fig. 2 ein Substrat mit einer Influenzsonde in Aufsicht auf die Sondenseite des Substrats.

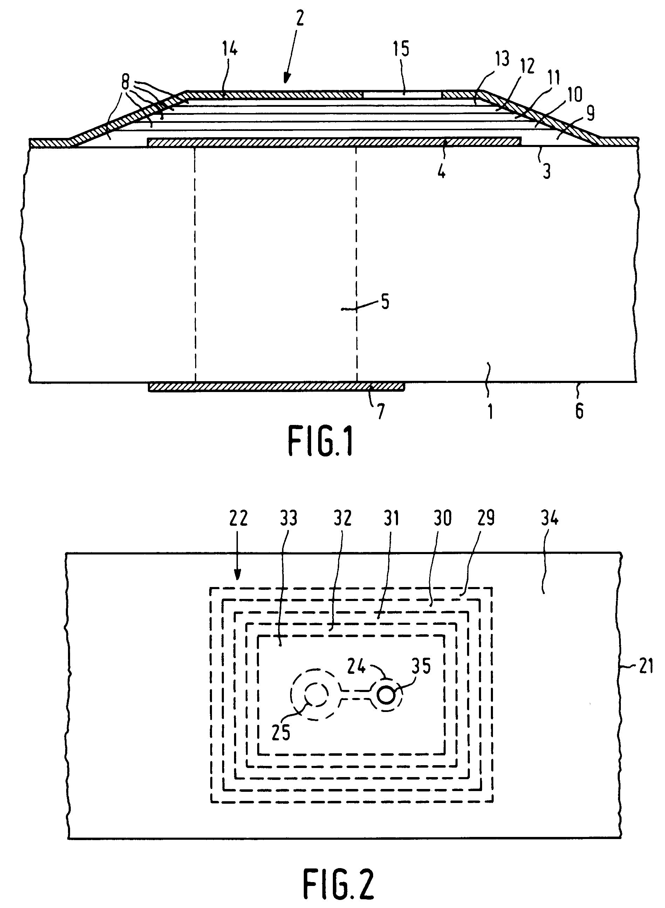

In Fig. 1 ist ein Ausschnitt eines Substrates 1 in Seitenansicht dargestellt. In dem in Fig. 1 dargestellten Ausschnitt ist auf das Substrat 1 eine Influenzsonde 2 in Dickschicht-Drucktechnik aufgebracht. Die Sonde 2 ist im Schnitt dargestellt.

Auf einer Sondenseite 3 des Substrates 1 ist eine Sondenelektrode 4 gebildet, welche teilweise im Bereich einer in der Figur nur angedeuteten Öffnung 5 des Substrates 1 vorgesehen ist. Die Öffnung 5 in dem Substrat 1 dient einer Durchkontaktierung der Sonde 4, welche in der Weise vorgenommen ist, daß elektrisch leitendes Material in in der Figur nicht dargestellter Weise die Öffnung 5 ausfüllt und auf einer Gegenseite 6 des Substrats austritt und dort einen elektrischen Anschluß 7 formt. An diesen elektrischen Anschluß 7 kann beispielsweise eine in der Figur nicht dargestellte Schaltungsanordnung zur Verstärkung der auf die Sondenelektrode 4 influenzierten Ströme vorgesehen sein.

Auf der Sondenseite 3 des Substrates 1 ist auf die Sondenelektrode 4 eine ebenfalls mittels Dickschicht-Drucktechnik erzeugte Isolierschicht 8 aufgebracht, welche mittels mehrerer Teil-Isolierschichten 9, 10, 11, 12 und 13 erzeugt ist. Dabei ist die Isolierschicht 8 so ausgestaltet, daß sie die Sondenelektrode 4, auch zu deren Seiten hin, vollständig abdeckt. Dies gilt auch für die Teil-Isolierschicht 9. Die Teil-Isolierschicht 10 ist dagegen in ihrer Flächenausdehnung etwas kleiner gewählt als die Teil-Isolierschicht 9. Auch die darüberliegenden Teil-Isolierschichten 11, 12 und 13 sind jeweils etwas kleiner gewählt als die jeweils darunterliegende. Dies führt dazu, daß die aus den Teil-Isolierschichten 9 bis 13 gebildete Isolierschicht 8 sich nach oben hin verjüngt.

Die Sondenseite 3 des Substrates 1 ist auch im Bereich der Isolierschicht, mittels einer elektrisch leitfähigen Deckschicht 14 abgedeckt. Die Deckschicht 14 weist eine Öffnung 15 auf, welche oberhalb desjenigen Bereiches der Sondenelektrode 4 angeordnet ist, auf den Ladung influenziert werden soll. Dieser Bereich ist neben dem Bereich der Durchkontaktierung 5 vorgesehen.

Die Öffnung 15 der elektrisch leitfähigen Deckschicht 14, welche in in der Figur nicht dargestellter Weise auf ein festes Potential gelegt ist, wird oft auch als Apertur bezeichnet. Diese Apertur bestimmt denjenigen Bereich, in dem die Ladungsverteilung z.B. einer in der Figur nicht dargestellten Selenplatte abgetastet wird. Dazu ist die Deckschicht 14 im Bereich der Öffnung 15 in einem genau definierten Abstand zu der Selenplatte zu bringen.

Die in Fig. 1 dargestellte Sonde kann z.B. eine Höhe von etwa 100 µm aufweisen.

In Fig. 2 ist ein Ausschnitt der Sondenseite eines Substrates 21 dargestellt, auf welchem eine Influenzsonde 22 angeordnet ist. Die Influenzsonde 22 gemäß Fig. 2 weist dabei etwas andere Abmessungen bzw. Größenverhältnisse auf als die Influenzsonde 2 nach Fig. 1.

In der Darstellung gemäß Fig. 2 ist in der Aufsicht lediglich eine Deckschicht 34 erkennbar, welche eine kreisförmige Öffnung 35 aufweist.

Alle übrigen Elemente der Sonde 22 sind in der Aufsicht an sich nicht erkennbar und in der Fig. 2 zur Verdeutlichung in gestrichelter Form dargestellt.

Unterhalb der Deckschicht 34 ist im Bereich der Influenzsonde 22 eine Isolierschicht vorgesehen, welche aus Teil-Schichten 29 bis 33 gebildet ist. Wie in der Fig. 2 angedeutet ist, weist dabei die unterste Teil-Isolierschicht 29 die größte Flächenausdehnung auf, während die darüberliegenden Teil-Isolierschichten bis hin zur Isolierschicht 33 eine jeweils kleinere Flächenausdehnung aufweisen als die jeweils darunterliegende Teil-Isolierschicht.

Unterhalb der Isolierschicht ist eine Sondenelektrode 24 vorgesehen, welche in einem ersten kreisförmigen Bereich unterhalb der Öffnung 35 der Deckschicht 34 angeorndet ist. Auf diesen Bereich der Sondenelektrode 24 soll Ladung durch die Öffnung 35 der Deckschicht 34 hindurch influenziert werden.

In einem anderen Bereich der Influenzsonde 24, auf den keine Ladung influenziert wird, und welcher in genügendem Abstand zu der Öffnung 35 der Deckschicht 34 angeordnet ist, ist eine Öffnung 25 in dem Substrat 21 vorgesehen. In diesem Bereich ist die Deckschicht in in der Figur nicht dargestellter Weise elektrisch zur Gegenseite des Substrates 21 hin durchkontaktiert.

In der Darstellung gemäß Fig. 2 wird deutlich, daß die Durchkontaktierung in einem solchen Abstand zu der Öffnung 35 in der Deckschicht 34 angeordnet ist, daß auch eventuelle Störungen in der Oberfläche der Sondenelektrode 24 im Bereich der Durchkontaktierung 25 sich in demjenigen Bereich der Sondenelektrode der unterhalb der Öffnung 35 angeordnet ist und auf den Ladung influenziert werden soll, nicht mehr auswirkt.

## Patentansprüche

1. Influenzsonde zur Erfassung der Ladung auf einer elektrisch aufgeladenen Oberfläche, wobei die Sonde eine auf einer Seite (3) eines Substrats (1) vorgesehene Sondenelektrode (4) mit
- einer auf diese aufgebrachten Isolierschicht (8)
- und einer auf der Isolierschicht vorgesehenen, elektrisch leitenden Deckschicht (14), die in demjenigen Bereich der Sondenelektrode (4), auf den Ladung influenziert werden soll, eine Öffnung (15) aufweist,
dadurch gekennzeichnet, daß das Substrat wenigstens auf der mit der Sondenelektrode (4) versehenen Seite (3) eben ist, daß die Sondenelektrode (4), die Isolierschicht (8) und die Deckschicht (14) mittels Dickschicht-Drucktechnik aufgebracht sind, daß die Sondenelektrode (4) von der Isolierschicht (8) vollständig abgedeckt und diese ihrerseits von der Deckschicht (14) bedeckt ist, daß die Sondenelektrode durch eine Substratöffnung (5) zu einem Anschluß (7) auf der Gegenseite (6) des Substrats elektrisch durchkontaktiert ist und daß die Durchkontaktierung mittels Dickschicht-Drucktechnik gebildet ist.

2. Influenzsonde nach Anspruch 1,
dadurch gekennzeichnet, daß die Durchkontaktierung der Sondenelektrode (4) außerhalb desjenigen Bereichs der Elektrode (4) angeordnet ist, auf den Ladung influenziert werden soll.

3. Influenzsonde nach einem der vorhergehenden Ansprüche,
dadurch gekennzeichnet, daß die Deckschicht (14) auf ein festes elektrisches Potential, vorzugsweise auf Masse, gelegt ist.

4. Influenzsonde nach einem der vorhergehenden Ansprüche,
dadurch gekennzeichnet, daß die Isolierschicht (8) in mehreren Teil-Isolierschichten (9, 10, 11, 12, 13) aufgebracht ist.

5. Influenzsonde nach Anspruch 4,
dadurch gekennzeichnet, daß die auf die Sondenelektrode (4) aufgebrachte Teil-Isolierschicht (9) diese vollständig abdeckt, daß die weiteren Teil-Isolierschichten (10, 11, 12, 13) zur Deckschicht (14) hin eine abnehmende Flächenausdehnung aufweisen und daß die unter der Deckschicht (14) befindliche Teil-Isolierschicht (13) sich wenigstens unterhalb der Öffnung (15) der Deckschicht (14) erstreckt.

6. Influenzsonde nach einem der vorhergehenden Ansprüche,
dadurch gekennzeichnet, daß die Sondenelektrode (4) mittels der Durchkontaktierung mit einer auf der Gegenseite des Substrats (1) angeordneten Schaltungsanordnung zur Signalverstärkung verbunden ist.

7. Influenzsonde nach einem der vorhergehenden Ansprüche,
dadurch gekennzeichnet, daß bei Anordnung mehrerer Sonden nebeneinander auf einem Substrat die Deckschicht (14) der Influenzsonde Teil der für alle Sonden gemeinsamen Deckschicht (14) ist.

## Claims

1. An electrostatic probe for the detection of the charge on a electrically charged surface, the probe comprising a probe electrode (4) provided on one side (3) of a substrate (1), with
- a insulating layer (8) provided thereon
- and an electrically conductive cover layer (14) which is provided on the insulating layer and which comprises an aperture (15) at the area of the probe electrode (4) on which charge is to be influenced,
characterized in that the substrate is flat, at last on the side (3) provided with the probe electrode (4), that the probe electrode (4), the insulating layer (8) and the cover layer (14) are provided by way of a thick-film printing technique, that the probe electrode (4) is fully covered by the insulating layer (8) which itself is covered by the cover layer (14), that the probe electrode is electrically through-connected, via a substrate aperture (5), to a terminal (7) on the other side (6) of the substrate, and that the through-connection is realised by way of a thick-film printing technique.

2. An electrostatic probe as claimed in Claim 1, characterized in that through-connection of the probe electrode (4) is arranged outside the area of the electrode (4) on which charge is to be influenced.

3. An electrostatic probe as claimed in any one of the preceding Claims, characterized in that the cover layer (14) is connected to a fixed electrical potential, preferably ground.

4. An electrostatic probe as claimed in any one of the preceding Claims, characterized in that the insulating layer (8) is provided as a plurality of insulating sublayers (9, 10, 11, 12, 13).

5. An electrostatic probe as claimed in Claim 4, characterized in that the insulating sub-layer (9) provided on the probe electrode (4) completely covers said electrode, that the square dimensions of the further insulating sub-layers (10, 11, 12, 13) decrease towards the cover layer (14), and that the insulating sub-layer (13) situated underneath the cover layer (14) extends at last underneath the aperture (15) in the cover layer (14).

6. An electrostatic probe as claimed in any one of the preceding Claims, characterized in that the probe electrode (4) is connected, by way of the through-connection, to a circuit arrangement for signal amplification which is provided on the opposite side of the substrate (1).

7. An electrostatic probe as claimed in any one of the preceding Claims, characterized in that when several probes are adjacently arranged on one substrate, the cover layer (14) of the influence probe forms part of the cover layer (14) common to all probes.

## Revendications

1. Sonde à influence pour capter la charge sur une surface chargée électriquement, la sonde comportant une électrode de sonde (4) prévue sur un côté (3) d'un substrat (1) avec :
- une couche isolante (8) appliquée sur cette électrode, et
- une couche de couverture (14) conductrice de l'électricité prévue sur la couche isolante, cette couche de couverture présentant une ouverture (15) dans la zone de l'électrode de sonde (4) qui doit être influencée par la charge, caractérisée en ce que le substrat est plan au moins du côté (3) pourvu de l'électrode de sonde (4), que l'électrode de sonde (4), la couche isolante (8) et la couche de couverture (14) sont appliquées par une technique d'impression à couches épaisses, que l'électrode de sonde (4) est recouverte complètement par la couche isolante (8) et que celle-ci est recouverte pour sa part par la couche de couverture (14), que l'électrode de sonde est mise en contact électrique par métallisation, à travers une ouverture (5) du substrat, avec une borne (7) qui se trouve au verso (6) du substrat et que la métallisation de mise en contact est formée par une technique d'impression à couches épaisses.

2. Sonde à influence selon la revendication 1, caractérisée en ce que la métallisation de mise en contact de l'électrode de sonde (4) est agencée à l'extérieur de la zone de l'électrode (4) qui doit être influencée par la charge.

3. Sonde à influence selon l'une quelconque des revendications précédentes, caractérisée en ce que la couche de couverture (14) est mise à un potentiel électrique fixe, de préférence à la masse.

4. Sonde à influence selon l'une quelconque des revendications précédentes, caractérisée en ce que la couche isolante (8) est appliquée en plusieurs couches isolantes partielles (9, 10, 11, 12, 13).

5. Sonde à influence selon la revendication 4, caractérisée en ce que la couche isolante partielle (9) appliquée sur l'électrode de sonde (4) recouvre celle-ci complètement, en ce que les autres couches isolantes partielles (10, 11, 12, 13) présentent en direction de la couche de couverture (14) une surface décroissante et que la couche isolante partielle (13) qui se trouve en dessous de la couche de couverture (14) s'étend au moins en dessous de l'ouverture (15) de la couche de couverture (14).

6. Sonde à influence selon l'une quelconque des revendications précédentes, caractérisée en ce que l'électrode de sonde (4) est connectée par la métallisation de mise en contact à un montage de circuit agencé au verso du substrat (1) et destiné à amplifier les signaux.

7. Sonde à influence selon l'une quelconque des revendications précédentes, caractérisée en ce que, lors de l'agencement de plusieurs sondes les unes à côté des autres sur un substrat, la couche de couverture (14) de la sonde à influence fait partie de la couche de couverture (14) commune à toutes les sondes.
